# EUROPEAN PATENT SPECIFICATION

(11) **EP 3 289 592 B1**
(45) Date of publication and mention of the grant of the patent: **15.01.2020**
(21) Application number: 16715080.4
(22) Date of filing: 06.04.2016
(51) Int. Cl.: H01B 1/22, C03C 3/12, C09D 5/24, H01L 31/0224, H01L 31/04, C03C 8/02, C03C 8/04

(54) **CONDUCTIVE PASTE, ELECTRODE AND SOLAR CELL**
LEITFÄHIGE PASTE, ELEKTRODE UND SOLARZELLE
PÂTE CONDUCTRICE, ÉLECTRODE ET CELLULE SOLAIRE

(30) Priority: 27.04.2015 GB 201507148
(43) Date of publication of application: 07.03.2018
(73) Proprietor: Johnson Matthey Public Limited Company, London EC4A 4AB (GB)
(72) Inventor: BOOTH, Jonathan Charles Shepley, Henley-on-Thames Oxfordshire RG9 1NB (GB); DROSTE, Tobias, 64367 Muehltal (DE); CELA GREVEN, Beatriz, 52064 Aachen (DE); NOWAK, Nicolas, Reading Berkshire RG4 9RU (GB)
(74) Representative: Atkinson, Ian Anthony
(86) International application number: PCT/GB2016/050960
(87) International publication number: WO 2016/174390

(56) References cited:
- CN-A- 102 515 513
- CN-A- 104 150 777
- TW-A- 201 431 100
- US-A1- 2014 008 587
- US-A1- 2014 216 540

## Description

### Field of the Invention

The present invention relates to conductive pastes suitable for use in solar cells, to a method of manufacturing a light receiving surface electrode of a solar cell, and to a light receiving surface of a solar cell.

### Background of the Invention

Screen printed metal (e.g. silver) pastes are routinely used as conductive tracks for solar cells, such as silicon solar cells. The pastes typically comprise metal (e.g. silver) powder, mixed oxide (e.g. glass frit), and sometimes one or more additional additives, all dispersed in an organic medium. The mixed oxide has several roles. During firing, it becomes a molten phase and so acts to bond the conductive track to the semiconductor wafer. However, the mixed oxide is also important in etching away the anti-reflective top layer (usually silicon nitride) provided on the surface of the semiconductor wafer, to permit direct contact between the conductive track and the semiconductor. The mixed oxide is typically also important in forming an ohmic contact with the n-type semiconductor emitter.

The quality of the contact between the conductive track and the semiconductor wafer is instrumental in determining the efficiency of the final solar cell. The best mixed oxides need to be optimised to flow at the correct temperature, and to provide the correct degree of etching of the antireflective layer. If too little etching is provided, then there will be insufficient contact between the semiconductor wafer and the conductive track, resulting in a high contact resistance. Conversely, excessive etching may lead to deposition of large islands of silver in the semiconductor, disrupting its p-n junction and thereby reducing its ability to convert solar energy into electrical energy.

Much recent attention has focussed on improving the mixed oxide materials included in conductive pastes for photovoltaic cells, to provide a good balance of properties.

CN 104 150 777 discloses tellurium-containing glass for solar positive electrode silver paste. The tellurium-containing glass is characterized by comprising the following components in mole percent: 15--60 percent of TeO₂, 3-25 percent of ZnO, 1-25 percent of P₂O₅, 0-30 percent of Nb₂O₅, 5-55 percent of Bi₂O₃, 0-20 percent of BaO, 0-20 percent of MgO, 0-30 percent of WO₃, 0-30 percent of MoO₃, 1-25 percent of SiO₂ and Al₂O₃, 0-5 percent of CuO, 0-5 percent of CeO₂ and 0-5 percent of R₂O.

TW 201 431 100 discloses a composition for solar cell electrodes and electrodes fabricated using the same. The composition includes a silver (Ag) powder; a glass frit containing 0.1 mole% to 50 mole% of elemental silver; and an organic vehicle.

### Summary of the Invention

There remains a need for mixed oxides (e.g. glass frits) which are suitable for use in conductive pastes for solar cells, which offer a good balance of properties. In particular, there remains a need for mixed oxides suitable for use in conductive pastes for solar cells which provide an excellent contact resistance without negatively influencing the p-n junction of a solar cell, and which flow at a suitable temperature for firing the conductive paste during manufacture of a solar cell. In particular, there remains a need for lead-free mixed oxides, or mixed oxides which contain a very low level of lead, which achieve these aims.

As demonstrated in the examples below, the present inventors have found that an excellent balance of properties can be achieved with a mixed oxide comprising cerium, for example comprising tellurium, bismuth and cerium. The present inventors have additionally found that pastes comprising mixed oxide according to the invention exhibit good or excellent adhesion properties, as demonstrated in the examples below.

Accordingly, in a first aspect, the present invention provides a conductive paste for a solar cell, the paste comprising a solids portion dispersed in an organic medium, the solids portion comprising electrically conductive metal, and glass frit, wherein the glass frit consists essentially of:
35 to 65 wt% TeO₂;
20 to 50 wt% Bi₂O₃;
0.1 to 5 wt% Li₂O;
0 to 5 wt% Na₂O;
0.1 to 5 wt% ZnO;
0 to 3 wt% MoO₃;
0.5 to 15 wt% CeO₂;
0 to 3 wt% WO₃;
0 to 5 wt% BaO;
0 to 10 wt% P₂O₅;
0 to 10 wt% of further components selected from the group consisting of GeO₂, CaO, ZrO₂, CuO, AgO and Al₂O₃; and
incidental impurities.

The glass frit (hereinafter referred to as mixed oxide) is substantially lead-free and substantially silicon-free.

The mixed oxide useful in the present invention is typically a powder. The mixed oxide is typically a glass frit having a composition as recited herein, or a mixture of one or more glass frits which together provide that composition.

In a second aspect, the present invention provides a method for the manufacture of a light receiving surface electrode of a solar cell, the method comprising applying a conductive paste according to the first aspect to a semiconductor substrate, and firing the applied conductive paste.

In a third aspect, the present invention provides a light receiving electrode for a solar cell, the light receiving electrode comprising a conductive track on a semiconductor substrate, wherein the conductive track is obtained or obtainable by firing a paste according to the first aspect on the semiconductor substrate.

In a fourth aspect the present invention provides use of a conductive paste according to the first aspect in the manufacture of a light receiving surface electrode of a solar cell.

### Brief Description of the Drawings

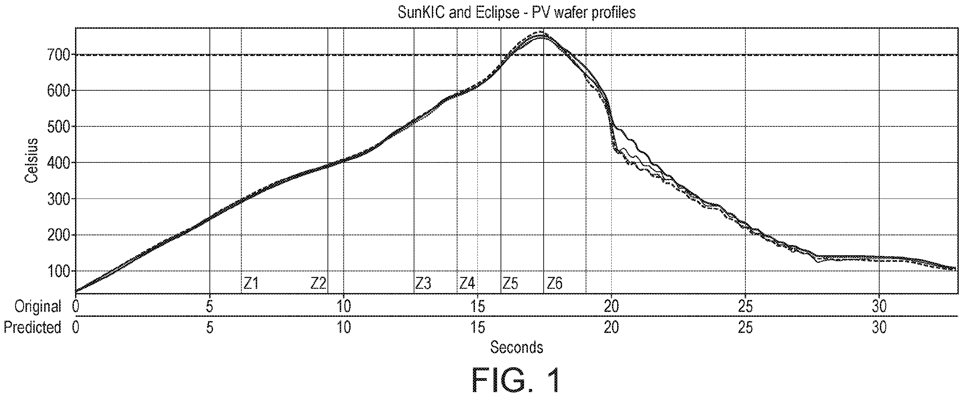

**Figure 1** shows an example firing curve for a solar cell prepared in the Examples.

### Detailed Description

Preferred and/or optional features of the invention will now be set out. Any aspect of the invention may be combined with any other aspect of the invention unless the context demands otherwise. Any of the preferred and/or optional features of any aspect may be combined, either singly or in combination, with any aspect of the invention unless the context demands otherwise.

### Mixed Oxide Composition

The mixed oxide compositions described herein are given as weight percentages. These weight percentages are with respect to the total weight of the mixed oxide. The weight percentages are the percentages of the components used as starting materials in preparation of the mixed oxide compositions, on an oxide basis. As the skilled person will understand, starting materials such as oxides, carbonates or nitrates may be used in preparing the mixed oxides (e.g. glasses) of the present invention. Where a non-oxide starting material is used to supply a particular element to the mixed oxide, an appropriate amount of starting material is used to supply an equivalent molar quantity of the element had the oxide of that element been supplied at the recited wt%. This approach to defining mixed oxide (e.g. glass) compositions is typical in the art. As the skilled person will readily understand, volatile species (such as oxygen) may be lost during the manufacturing process of the mixed oxide, and so the composition of the resulting mixed oxide may not correspond exactly to the weight percentages of starting materials, which are given herein on an oxide basis. Analysis of a fired mixed oxide (e.g. glass) by a process known to those skilled in the art, such as Inductively Coupled Plasma Emission Spectroscopy (ICP-ES), can be used to calculate the starting components of the mixed oxide composition in question.

The mixed oxide is substantially lead-free. As used herein, the term "substantially lead-free" is intended to include mixed oxides which contain no intentionally added lead. For example, the mixed oxide may include less than 0.1 wt% PbO, for example less than 0.05 wt%, less than 0.01 wt% or less than 0.005 wt% PbO.

The mixed oxide is substantially boron-free. As used herein, the term "substantially boron-free" is intended to include mixed oxides which contain no intentionally added boron. For example, the mixed oxide may include less than 0.1 wt% B₂O₃, for example less than 0.05 wt%, less than 0.01 wt% or less than 0.005 wt% B₂O₃.

The mixed oxide includes TeO₂. The mixed oxide includes at least 35 wt%, at least 40 wt%, or at least 45 wt% of TeO₂. The mixed oxide includes 65 wt% or less or 60 wt% or less of TeO₂. In particular, the mixed oxide includes 35 to 65 wt% of TeO₂.

The mixed oxide includes Bi₂O₃. The mixed oxide includes at least 20 wt% or at least 25 wt% of Bi₂O₃. The mixed oxide includes 50 wt% or less or 45 wt% or less of Bi₂O₃. In particular, the mixed oxide may include 20 to 50 wt% of Bi₂O₃.

The mixed oxide includes CeO₂. The mixed oxide comprises at least 0.5 wt%, at least 1 wt%, at least 1.5 wt%, at least 2 wt%, at least 2.5 wt%, at least 3 wt% CeO₂, at least 3.5 wt% CeO₂, at least 4 wt% CeO₂, at least 4.5 wt% CeO₂, at least 5 wt% CeO₂, at least 6 wt% CeO₂, or at least 7 wt% CeO₂. The mixed oxide comprises 15 wt% or less, 14 wt% or less, 13 wt% or less, 12 wt% or less, 11 wt% or less, 10 wt% or less, or 5 wt% or less of CeO₂. A particularly suitable CeO₂ content is from 1 wt% to 15 wt%.

The mixed oxide is substantially silicon-free. As used herein, the term "substantially silicon-free" is intended to include mixed oxides which contain no intentionally added silicon. For example, the mixed oxide may include less than 0.1 wt% SiO₂, for example less than 0.05 wt%, less than 0.01 wt% or less than 0.005 wt% SiO₂.

The mixed oxide includes alkali metal oxide, in particular Li₂O and optionally one or more of Na₂O, K₂O, and Rb₂O, more preferably both of Li₂O and Na₂O.

The mixed oxide includes 0.1 wt% or more, 0.5 wt% or more or 1 wt% or more alkali metal oxide. The mixed oxide includes 10 wt% or less, 8 wt% or less, 7 wt% or less, 5 wt% or less, 4 wt% or less alkali metal oxide.

The mixed oxide includes 0 0.1 wt% or more, 0.5 wt% or more or 1 wt% or more Li₂O. The mixed oxide includes 5 wt% or lessor 4 wt% or less Li₂O. In particular, the mixed oxide includes 0.1 to 5 wt% of Li₂O.

In some embodiments, it may be preferred that the mixed oxide includes both Li₂O and Na₂O. The mixed oxide may include 0.1 wt% or more, 0.5 wt% or more, 1 wt% or more, 2 wt% or more or 3 wt% or more in total of Li₂O and Na₂O. The mixed oxide may include 10 wt% or less, 8 wt% or less, 7 wt% or less, 6 wt% or less 5 wt% or less, 4 wt% or less in total of Li₂O and Na₂O. The mixed oxide may include at least 0.1 wt% or at least 0.5 wt% of Li₂O and at least 0.1 wt% or at least 0.5 wt% of Na₂O. The mixed oxide may include 5 wt% or less, 4 wt% or less, 3 wt% or less or 2.5 wt% or less of Li₂O and 5 wt% or less, 4 wt% or less, 3 wt% or less or 2.5 wt% or less of Na₂O.

The mixed oxide includes ZnO. The mixed oxide includes 0.1 wt% or more, 0.5 wt% or more, 1 wt% or more or 1.5 wt% or more ZnO. The mixed oxide includes 5 wt% or less ZnO. In particular, the mixed oxide includes 0.1 to 5 wt% of ZnO.

IThe mixed oxide is substantially zinc-free. As used herein, the term "substantially zinc-free" is intended to include mixed oxides which contain no intentionally added zinc. For example, the mixed oxide may include less than 0.1 wt% ZnO, for example less than 0.05 wt%, less than 0.01 wt% or less than 0.005 wt% ZnO.

The mixed oxide may include MoO₃. For example, the mixed oxide includes 0 wt% or more, 0.1 wt% or more, 0.5 wt% or more of MoO₃. The mixed oxide includes 3 wt% or less of MoO₃. In particular, the mixed oxide includes 0 to 3 wt% of MoO₃.

In some embodiments, it may be preferred that the mixed oxide is substantially molybdenum-free. As used herein, the term "substantially molybdenum -free" is intended to include mixed oxides which contain no intentionally added molybdenum. For example, the mixed oxide may include less than 0.1 wt% MoO₃, for example less than 0.05 wt%, less than 0.01 wt% or less than 0.005 wt% MoO₃.

The mixed oxide may include WO₃. For example, the mixed oxide includes 0 wt% or more, 0.1 wt% or more, 0.5 wt% or more of WO₃. The mixed oxide includes 3 wt% or less of WO₃. In particular, the mixed oxide includes 0 to 3 wt% of WO₃.

In some embodiments, it may be preferred that the mixed oxide is substantially tungsten-free. As used herein, the term "substantially tungsten-free" is intended to include mixed oxides which contain no intentionally added tungsten. For example, the mixed oxide may include less than 0.1 wt% WO₃, for example less than 0.05 wt%, less than 0.01 wt% or less than 0.005 wt% WO₃.

The mixed oxide may include BaO. For example, the mixed oxide includes 0 wt% or more, 0.1 wt% or more, 0.5 wt% or more of BaO. The mixed oxide includes 5 wt% or less or 3 wt% or less of BaO. In particular, the mixed oxide includes 0 to 5 wt% of BaO.

The mixed oxide may include P₂O₅. For example, the mixed oxide includes 0 wt% or more, 0.1 wt% or more, 0.5 wt% or more or 1 wt% or more P₂O₅. The mixed oxide includes 10 wt% or less, 7 wt% or less, 5 wt% or less or 3 wt% or less P₂O₅.

The mixed oxide may include further components, such as further oxide components. Typically, the mixed oxide will include 10 wt% or less, 7 wt% or less, 5 wt% or less, 3 wt% or less, 2 wt% or less or 1 wt% or less in total of further components. The mixed oxide may include at least 0.1 wt% of further components. The further components may be one or more selected from the group consisting of GeO₂, CaO, ZrO₂, CuO, AgO and Al₂O₃.

The mixed oxide comprises:
35 to 65 wt% TeO₂;
20 to 50 wt% Bi₂O₃;
0.1 to 5 wt% Li₂O;
0 to 5 wt% Na₂O;
0.1 to 5 wt% ZnO;
0 to 3 wt% MoO₃; and
0.5 to 15 wt% CeO₂.

The mixed oxide (e.g. glass frit) consists essentially of a composition as described herein, and incidental impurities. In that case, as the skilled person will readily understand that the total weight % of the recited constituents will be 100 wt%, any balance being incidental impurities. Typically, any incidental impurity will be present at 0.1 wt% or less, 0.05 wt% or less, 0.01 wt% or less, 0.05 wt% or less, 0.001 wt% or less or 0.0001 wt% or less.

The mixed oxide consists essentially of:
35 to 65 wt% TeO₂;
20 to 50 wt% Bi₂O₃;
0.1 to 5 wt% Li₂O;
0 to 5 wt% Na₂O;
0.1 to 5 wt% ZnO;
0 to 3 wt% MoO₃;
0.5 to 15 wt% CeO₂;
0 to 3 wt% WO₃;
0 to 5 wt% BaO;
0 to 10 wt% P₂O₅;
0 to 10 wt% of further components, which may optionally be selected from the group consisting of GeO₂, CaO, ZrO₂, CuO, AgO and Al₂O₃; and
incidental impurities.

The solids portion of the conductive paste of the present invention may include 0.1 to 15 wt% of mixed oxide (e.g. glass frit). The solids portion of the conductive paste may include at least 0.5 wt% or at least 1 wt% of mixed oxide (e.g. glass frit). The solids portion of the conductive paste may include 10 wt% or less, 7 wt% or less or 5 wt% or less of mixed oxide (e.g. glass frit).

Typically, the mixed oxide (e.g. glass frit) will have a softening point in the range from 200°C to 400°C. For example, the mixed oxide may have a softening point in the range from 250°C to 350°C. The softening point may be determined e.g. using DSC measurement according to the standard ASTM E1356 "Standard Test Method for Assignment of the Glass Transition Temperature by Differential Scanning Calorimetry".

The particle size of the mixed oxide powder (e.g. glass frit) is not particularly limited in the present invention. Typically, the D50 particle size may be at least 0.1 µm, at least 0.5 µm, or at least 1 µm. The D50 particle size may be 15 µm or less, 10 µm or less, 5 µm or less, 4 µm or less, 3 µm or less or 2 µm or less or 1 µm or less. The particle size may be determined using a laser diffraction method (e.g. using a Malvern Mastersizer 2000).

Typically, the mixed oxide is a glass frit. Using X-ray diffraction techniques, the present inventors have found that some of the glass frits they have prepared in fact include a crystalline portion. Accordingly, it will be understood that the glass frits described and defined herein may include a crystalline portion in addition to an amorphous glass phase. In particular, the present inventors have found that some glass frits which include CeO₂ as a component in fact include a portion of crystalline CeO₂, in addition to the amorphous glass phase. This is observed particularly where the glass frit recipe includes a large weight percent of CeO₂, (e.g. 5 wt% or more). Accordingly, it will be understood that the glass frits described herein may include crystalline CeO₂, and that the recited CeO₂ content of the frit relates to the total of CeO₂ in amorphous glass phase and crystalline phase in the frit. Similarly, where another component is present in a crystalline portion, the recited content of that component in the frit relates to the total of that component in amorphous glass phase and crystalline phase in the frit. The glass frit is typically obtained or obtainable by a process as described or defined herein.

Typically, the glass frit is prepared by mixing together the raw materials and melting them to form a molten glass mixture, then quenching to form the frit. Accordingly, there is provided a process for preparing a glass frit, wherein the process comprises melting together starting materials for forming the frit, to provide a molten glass mixture, and quenching the molten glass mixture to form the frit. The process may further comprise milling the frit to provide the desired particle size.

The skilled person is aware of alternative suitable methods for preparing glass frit. Suitable alternative methods include water quenching, sol-gel processes and spray pyrolysis.

### Conductive Paste

Typically, the conductive paste is a front side conductive paste.

The solids portion of the conductive paste of the present invention may include 85 to 99.9 wt% of electrically conductive metal. For example, the solids portion may include at least 85 wt%, at least 90 wt%, at least 93 wt% or at least 95 wt% of electrically conductive metal. The solids portion may include 99.9 wt% or less, 99.5 wt% or less or 99 wt% or less of electrically conductive metal.

The electrically conductive metal may comprise one or more metals selected from silver, copper, nickel and aluminium. Preferably, the electrically conductive metal comprises or consists of silver.

The electrically conductive metal may be provided in the form of metal particles. The form of the metal particles is not particularly limited, but may be in the form of flakes, spherical particles, granules, crystals, powder or other irregular particles, or mixtures thereof.

The particle size of the electrically conductive metal is not particularly limited in the present invention. Typically, the D50 particle size may be at least 0.1 µm, at least 0.5 µm, or at least 1 µm. The D50 particle size may be 15 µm or less, 10 µm or less, 5 µm or less, 4 µm or less, 3 µm or less or 2 µm or less. The particle size may be determined using a laser diffraction method (e.g. using a Malvern Mastersizer 2000).

The solids portion of the conductive paste of the present invention may include 0.1 to 15 wt% of mixed oxide (e.g. glass frit). For example, the solids portion may include at least 0.2 wt%, at least 0.5 wt% or at least wt% of mixed oxide. The solids portion may include 10 wt% or less, 7 wt% or less or 5 wt% or less of mixed oxide.

The solids portion may include one or more additional additive materials, e.g. 0 to 10 wt% or 0 to 5 wt% of additional additive material.

### Organic Medium

The solids portion of the conductive paste of the present invention is dispersed in organic medium. The organic medium may constitute, for example, at least 2 wt%, at least 5 wt% or at least 9 wt% of the conductive paste. The organic medium may constitute 20 wt% or less, 15 wt% or less, 13 wt % or less or 10 wt % or less of the conductive paste.

Accordingly, it will be understood that the solids portion may constitute at least 80 wt%, at least 85 wt%, at least 87 wt% or at least 90 wt% of the conductive paste. The solids portion may constitute 98 wt% or less, 95 wt% or less or 91 wt% or less of the conductive paste.

The organic medium typically comprises an organic solvent with one or more additives dissolved or dispersed therein. As the skilled person will readily understand, the components of the organic medium are typically chosen to provide suitable consistency and rheology properties to permit the conductive paste to be printed onto a semiconductor substrate, and to render the paste stable during transport and storage.

Examples of suitable solvents for the organic medium include one or more solvents selected from the group consisting of butyl diglycol, butyldiglycol acetate, terpineol, diakylene glycol alkyl ethers (such as diethylene glycol dibutyl ether and tripropyleneglycol monomethylether), ester alcohol (such as Texanol ®), 2-(2-methoxypropoxy)-1-propanol and mixtures thereof.

Examples of suitable additives include those dispersants to assist dispersion of the solids portion in the paste, viscosity/rheology modifiers, thixotropy modifiers, wetting agents, thickeners, stabilisers and surfactants.

For example, the organic medium may comprise one or more selected from the group consisting of rosin (kollophonium resin), acrylic resin (e.g. Neocryl ®), alkylammonium salt of a polycarboxylic acid polymer (e.g. Dysperbik ® 110 or 111), polyamide wax (such as Thixatrol Plus ® or Thixatrol Max ®), nitrocellulose, ethylcellulose, hydroxypropyl cellulose and lecithin.

Typically, the conductive paste is prepared by mixing together electrically conductive metal, mixed oxide and the components of the organic medium, in any order. Also provided is a process for preparing a conductive paste according to the first aspect, wherein the process comprises mixing together the electrically conductive metal, the mixed oxide and the components of the organic medium, in any order.

### Manufacture of a Light Receiving Surface Electrode and Solar Cell

The skilled person is familiar with suitable methods for the manufacture of a light receiving surface electrode of a solar cell. Similarly, the skilled person is familiar with suitable methods for the manufacture of a solar cell.

The method for the manufacture of a light receiving surface electrode of a solar cell typically comprises applying a conductive paste onto the surface of a semiconductor substrate, and firing the applied conductive paste.

The conductive paste may be applied by any suitable method. For example, the conductive paste may be applied by printing, such as by screen printing or inkjet printing.

The skilled person is aware of suitable techniques for firing the applied conductive paste. An example firing curve is shown in Figure 1. A typical firing process lasts approximately 30 seconds, with the surface of the light receiving surface electrode reaching a peak temperature of about 800°C. Typically, the furnace temperature will be higher to achieve this surface temperature. The firing may for example last for 1 hour or less, 30 minutes or less, 10 minutes or less or 5 minutes or less. The firing may last at least 10 seconds. For example, the peak surface temperature of the light receiving surface electrode may be 1200°C or less, 1100°C or less, 1000°C or less, 950°C or less or 900°C or less. The peak surface temperature of the light receiving surface electrode may be at least 600°C.

The semiconductor substrate of the light receiving surface electrode may be a silicon substrate. For example, it may be a single crystal semiconductor substrate, or a multi crystal semiconductor substrate. Alternative substrates include CdTe. The semiconductor may for example be a p-type semiconductor or an n-type semiconductor.

The semiconductor substrate may comprise an insulating layer on a surface thereof. Typically, the conductive paste of the present invention is applied on top of the insulating layer to form the light receiving surface electrode. Typically, the insulating layer will be non-reflective. A suitable insulating layer is SiNx (e.g. SiN). Other suitable insulating layers include Si₃N₄, SiO₂, Al₂O₃ and TiO₂.

Methods for the manufacture of a solar cell typically comprise applying a back side conductive paste (e.g. comprising aluminium) to a surface of the semiconductor substrate, and firing the back side conductive paste to form a back side electrode. The back side conductive paste is typically applied to the opposite face of the semiconductor substrate from the light receiving surface electrode.

Typically, the back side conductive paste is applied to the back side (non-light receiving side) of the semiconductor substrate and dried on the substrate, after which the front side conductive paste is applied to the front side (light-receiving side) of the semiconductor substrate and dried on the substrate. Alternatively, the front side paste may be applied first, followed by application of the back side paste. The conductive pastes are typically co-fired (i.e. the substrate having both front- and back-side pastes applied thereto is fired), to form a solar cell comprising front- and back-side conductive tracks.

The efficiency of the solar cell may be improved by providing a passivation layer on the back side of the substrate. Suitable materials include SiNx (e.g. SiN), Si₃N₄, SiO₂, Al₂O₃ and TiO₂. Typically, regions of the passivation layer are locally removed (e.g. by laser ablation) to permit contact between the semiconductor substrate and the back side conductive track.

Where ranges are specified herein it is intended that each endpoint of the range in independent. Accordingly, it is expressly contemplated that each recited upper endpoint of a range is independently combinable with each recited lower endpoint, and vice versa.

### Examples

### Glass Synthesis

Glass frits were prepared using commercially available raw materials. The compositions of the glass frits are given in Table 1 below. Each glass was made according to the following standard procedure.

Raw materials for the glass were mixed using a laboratory mixer. One hundred grams of the mixture was melted in ceramic crucible, in a Carbolite electrical laboratory furnace. The crucibles containing the raw material mixture was placed in the furnace while it was still cold, to avoid thermal shock and cracking of the ceramic crucible. The melting was carried out at 950-1100 °C in air. The molten glass was quenched in water to obtain the glass frit. The frit was dried overnight in a Binder heating chamber at 120°C, then wet milled in a planetary mill to provide particles having a D50 particle size less than 1µm (determined using a laser diffraction method using a Malvern Mastersizer 2000). Wet milling may be carried out in organic solvent or water.

**Table 1 - Glass Frit Compositions**

| (Compositions in weight % on an oxide basis) | | | | | | | | | | |
|---|---|---|---|---|---|---|---|---|---|---|
| **Ex.** | **Code** | **PbO** | **SiO₂** | **Li₂O** | **TeO₂** | **ZnO** | **Bi₂O₃** | **MoO₃** | **CeO₂** | **Na₂O** |
| **1** | PVG65 | -- | 3.8 | 3.2 | 51.3 | 3.8 | 34.0 | -- | **3.9** | -- |
| **2** | PVG81 | -- | 4.4 | 3.7 | 44.4 | 4.4 | 38.7 | -- | **4.4** | -- |
| **3** | PVG82 | -- | 3.9 | 3.3 | 52.4 | 1.8 | 34.7 | -- | **3.9** | -- |
| **4** | PVG88 | -- | 4.0 | 3.3 | 55.3 | 4.0 | 29.4 | -- | **4.0** | -- |
| **5** | PVG77 | -- | 3.7 | 3.1 | 49.3 | 3.7 | 32.6 | -- | **7.6** | -- |
| **6** | BC186 | -- | -- | 2.5 | 45.0 | 3.0 | 36.5 | 2.0 | **11.0** | -- |
| **7** | BC239 | -- | -- | 2.5 | 45.0 | 3.0 | 36.5 | 1.0 | **11.0** | 1.0 |
| **8** | BC240 | -- | -- | 2.5 | 45.0 | 3.0 | 36.5 | -- | **11.0** | 2.0 |
| **9** | BC263 | -- | -- | 2.6 | 46.4 | -- | 37.6 | -- | **11.3** | 2.1 |
| **10** | BC257 | -- | -- | 2.6 | 47.6 | 3.2 | 38.6 | -- | **5.8** | 2.2 |
| **11** | BC258 | -- | -- | 2.7 | 49.5 | 3.3 | 40.1 | -- | **2.2** | 2.2 |
| **12** | BC259 | -- | -- | 2.8 | 50.0 | 3.3 | 40.6 | -- | **1.1** | 2.2 |
| **13** | BC241 | -- | -- | 2.5 | 45.0 | 3.0 | 34.5 | -- | **11.0** | 4.0 |
| **14** | BC242 | -- | -- | 2.5 | 45.0 | 6.0 | 33.5 | -- | **11.0** | 2.0 |
| **15** | BC243 | -- | -- | 2.5 | 45.0 | 9.0 | 30.5 | -- | **11.0** | 2.0 |
| **CE1** | BC143 | 17.0 | -- | 2.5 | 45.0 | 3.0 | 21.5 | -- | **11** | -- |
| **CE2** | PVG74 | -- | 4.0 | 3.3 | 53.4 | 4.0 | 35.3 | -- | -- | -- |
| **CE3** | BC260 | -- | -- | 2.8 | 50.6 | 3.4 | 41.0 | -- | -- | 2.2 |
| **CE4** | BC229 | 27.0 | -- | -- | 43.5 | 3.0 | 23.0 | -- | -- | 3.5 |
| **CE5** | BC493 | -- | 2.4 | 2.4 | 43.9 | 2.9 | 35.6 | 1.0 | 10.7 | 1.0 |
| **CE6** | BC494 | -- | 9.1 | 2.3 | 41 | 2.7 | 33 | 0.9 | 10 | 0.9 |

| | | | | | | | | | | |
|---|---|---|---|---|---|---|---|---|---|---|
| (CE means Comparative Example) **It should be noted that examples 14 and 15 have ZnO content above 5 wt% and thus fall outside the compositions as now defined in claim 1.** | | | | | | | | | | |

The glass transition temperature of each of the glasses was determined, using Differential Scanning Calorimetry, according to ASTM E1356 "Standard Test Method for Assignment of the Glass Transition Temperature by Differential Scanning Calorimetry". The results are shown in Table 2 below:

**Table 2 - Glass Transition Temperatures**

| **Ex.** | **Code** | **Tg (°C)** |
|---|---|---|
| **1** | PVG65 | 271 |
| **2** | PVG81 | 272 |
| **3** | PVG82 | 275 |
| **4** | PVG88 | 281 |
| **5** | PVG77 | 276 |
| **6** | BC186 | 280 |
| **7** | BC239 | 278 |
| **8** | BC240 | 270 |
| **9** | BC263 | 280 |
| **10** | BC257 | 259 |
| **11** | BC258 | 272 |
| **12** | BC259 | 279 |
| **13** | BC241 | 264 |
| **14** | BC242 | 276 |
| **15** | BC243 | 280 |
| **CE1** | BC143 | 268 |
| **CE2** | PVG74 | 275 |
| **CE3** | BC260 | 277 |
| **CE4** | BC229 | 263 |
| **CE5** | BC493 | 265 |
| **CE6** | BC494 | 290 |

These glass transition temperatures are acceptable for silver pastes for photovoltaic applications.

### Paste Preparation

Conductive silver pastes comprising each of the glass frits was prepared using 87-88 wt% of a commercial silver powder, 3-2 wt% of glass frit, the balance being standard organic medium. The paste was prepared by pre-mixing all the components and passing several times in a triple roll mill, producing a homogeneous paste.

### Preparation of Solar Cells

Multicrystalline wafers with sheet resistance of 90 Ohm/sq , 6 inches size, were screen printed on their back side with commercially available aluminium paste, dried in an IR Mass belt dryer and randomized in groups. Each of these groups was screen printed with a front side silver paste prepared as described above.

The screens used for the front side pastes had finger opening 40 µm. After printing the front side the cells were dried in the IR Mass belt dryer and fired in a Despatch belt furnace. The Despatch furnace had six firing zones with upper and lower heaters. The first three zones are programmed around 500°C for burning of the binder from the paste, the fourth and fifth zone are at a higher temperature, with a maximum temperature of 945 °C in the final zone (furnace temperature). The furnace belt speed for this experiment was 610 cm/min. An example firing profile is shown in Figure 1. The recorded temperature was determined by measuring the temperature at the surface of the solar cell during the firing process, using a thermocouple.

After cooling the fired solar cells were tested in an I-V curve tracer from Halm, model cetisPV-CTL1. The results are shown in Table 3 below. The results are arranged in order of increasing fill factor (FF). The results shown in Table 4 are provided by the I-V curve tracer, either by direct measurement or calculation using its internal software.

(To minimize the influence of the contact area the cells were prepared using the same screen for printing, and the same viscosity paste in each individual test set. This ensures that the line widths of the compared pastes were substantially identical and had no influence on the measuring.)

The results shown in Table 3 are median values from the measurement of 5 cells of each paste. In test PV106, test PV137, test PV131, test PV154 and test PV244 different batches of silicon wafer were used. This can affect cell performance. In tests PV106, PV137 and PV131, a reference sample was prepared using a commercially available paste (referred to as "Reference Paste").

Note that the performance of the Reference Paste is not comparable with the Examples and Comparative Examples, due to other variables such as silver content, silver type, organics content, glass frit content. These variables were kept constant between the Examples and Comparative Examples, but the Reference Paste was used as supplied. Comparison of the Examples with the Reference Paste does not indicate the relative performance of the glass frits in the pastes, as variation in performance may be due to other variables.

**Table 3 - Solar Cell Test Results**

| **Ex.** | **Code** | **Glass content in the paste (wt.%)** | **Comment** | **FF (%)** | **SunsVoc FF (%)** | **Eta (%)** | **Uoc (V)** | **Series Resistance (Ohm·cm²)** |
|---|---|---|---|---|---|---|---|---|
| **Test PV106** | | | | | | | | |
| **Reference Paste** | | Commercial Paste (Pb-containing) | | 79.45 | 82.00 | 17.07 | 0.6260 | 0.0020 |
| **CE1** | PVG74 | 3 | Pb-free, Ce-free | 45.95 | 82.72 | 9.66 | 0.6207 | 0.0321 |
| **1** | PVG65 | 3 | 3.8 wt% CeO₂ | 78.87 | 82.01 | 17.08 | 0.6285 | 0.0025 |
| **2** | PVG77 | 3 | 7.6 wt% CeO₂ | 76.31 | 81.93 | 16.40 | 0.6271 | 0.0048 |
| **3** | PVG81 | 3 | 4.4 wt% CeO₂ | 78.16 | 81.53 | 16.82 | 0.6243 | 0.0029 |
| **4** | PVG82 | 3 | 3.9 wt% CeO₂ | 78.06 | 81.16 | 16.80 | 0.6223 | 0.0025 |
| **5** | PVG88 | 3 | 4.0 wt% CeO₂ | 77.74 | 81.34 | 16.66 | 0.6234 | 0.0029 |

| **Test PV137** | | | | | | | | |
|---|---|---|---|---|---|---|---|---|
| **Reference Paste** | | Commercial Paste (Pb-containing) | | 78.61 | 81.36 | 17.42 | 0.6240 | 0.0022 |
| **6** | BC186 | 2 | 11.0 wt% CeO₂ | 78.35 | 81.92 | 17.51 | 0.6268 | 0.0028 |
| **7** | BC239 | 2 | 11.0 wt% CeO₂ | 78.96 | 82.06 | 17.62 | 0.6265 | 0.0024 |
| **8** | BC240 | 2 | 11.0 wt% CeO₂ | 78.97 | 81.99 | 17.60 | 0.6261 | 0.0023 |

| **Test PV131** | | | | | | | | |
|---|---|---|---|---|---|---|---|---|
| **Reference Paste** | | Commercial Paste (Pb-containing) | | 78.57 | 81.70 | 17.43 | 0.6262 | 0.0023 |
| **CE1** | BC143 | 2 | Pb-containing 11.0 wt% CeO₂ | 78.43 | 81.89 | 17.35 | 0.6266 | 0.0027 |

| **Test PV154** | | | | | | | | |
|---|---|---|---|---|---|---|---|---|
| **6** | BC239 | 2 | 11.0wt-% CeO₂ | 78.07 | 81.26 | 17.36 | 0.6240 | 0.0025 |
| **CE3** | BC260 | 2 | Pb-free, Ce-free | 76.10 | 78.64 | 16.65 | 0.6174 | 0.0020 |

| **Test PV244** | | | | | | | | |
|---|---|---|---|---|---|---|---|---|
| **7** | BC239 | 2 | Pb-free, Si-free, 11.0 wt% CeO₂ | 78.80 | 82.21 | 17.73 | 0.635 | 0.0027 |
| **CE5** | BC493 | 2 | Pb-free, 2.4wt% SiO₂, 10.7wt% CeO₂ | 78.73 | 82.13 | 17.70 | 0.635 | 0.0028 |
| **CE6** | BC494 | 2 | Pb-free, 9.1wt% SiO₂,10wt% CeO₂ | 78.55 | 81.84 | 17.62 | 0.632 | 0.0026 |

Fill factor (FF) indicates the performance of the solar cell relative to a theoretical ideal (0 resistance) system. The fill factor correlates with the contact resistance - the lower the contact resistance the higher the fill factor will be. But if the glass frit of the conductive paste is too aggressive it could damage the pn junction of the semiconductor. In this case the contact resistance would be low but due to the damage of the pn junction (recombination effects and lower shunt resistance) a lower fill factor would occur. A high fill factor therefore indicates that there is a low contact resistance between silicon wafer and the conductive track, and that firing of the paste on the semiconductor has not negatively affected the pn junction of the semiconductor (i.e. the shunt resistance is high). A fill factor of 76% or above, preferably 77% or above, is desirable.

The quality of the pn junction can be determined by measuring the pseudo fill factor (SunsVocFF). This is the fill factor independent of losses due to resistance in the cell. Accordingly, the lower the contact resistance and the higher the SunsVoc FF, the higher the resulting fill factor will be. The skilled person is familiar with methods for determining SunsVoc FF, for example as described in Reference 1. SunsVoc FF is measured under open circuit conditions, and is independent of series resistance effects.

Eta represents the efficiency of the solar cell, comparing solar energy in to electrical energy out. Efficiency of a high quality cell is typically in the range from 17% to 18%. Small changes in efficiency can be very valuable in commercial solar cells.

The open-circuit voltage, Uoc, is the maximum voltage available from a solar cell, and this occurs at zero current. The open-circuit voltage corresponds to the amount of forward bias on the solar cell due to the bias of the solar cell junction with the light-generated current. The Uoc value may be reduced if the paste damages the p-n junction.

### Further Paste Testing (XRD and Adhesion Properties)

### X-RayDiffraction (XRD)

XRD was carried out on some of the glass powder samples, for crystallographic characterization. The analysis were made using a diffractometer Bruker D8, operating with CuKα radiation (1.5045 Å). Data were collected using a point detector in the 2θ range of 20-60° with a step of 0.01°. The results are shown in Table 4 below.

### Soldering and pull test of solar cells

All samples were soldered and tested with the same parameters and equipment. The soldering processed and pull strength tests were compatible with industrial processes and industrial equipment. The laboratory soldering system and pull tester were produced by Somont. The samples were soldered at 320 °C for 1.5 s. For this test, commercially available Cu-core 62Sn/36Pb/2Ag ribbons with 0.2^{∗}1.5 mm were used, made by Kunming Sunlight Science and Tech. The pull forces were measured under an angle of 180°. The pull force results presented in Table 5 are median results from the test of 9 busbars of each paste. All pastes were prepared with 2 wt% glass frit, 88 wt% silver powder and 10 wt% organic medium.

**Table 4 - XRD and Pull Test Results**

| **Ex.** | **Code** | **XRD results** | **Pull Force N** |
|---|---|---|---|
| **7** | BC239 | Partially crystallized | 6.8 |
| **8** | BC240 | Partially crystallized | 6.8 |
| **13** | BC241 | Partially crystallized | 7.5 |
| **14** | BC242 | Partially crystallized | 7.5 |
| **15** | BC243 | Partially crystallized | 6.6 |
| **CE3** | BC260 | Amorphous | Not tested |
| **CE4** | BC229 | Amorphous | 4.0 |

Without wishing to be bound by theory, the present inventors believe that the excellent adhesion properties observed for pastes according to the present invention are predominantly due to the properties of the glass frit. They consider that it is a combination of (i) the excellent glass flow behaviour of the frits of the present invention, and (ii) the reinforcement of the glass matrix by the crystalline phases observed by XRD, which are believed to be a result of the presence of CeO₂ in the frit.

### References

1. A. McEvoy, T. Markvart, L. Castaner. Solar cells: Materials, Manufacture and Operation. Academic Press, second edition, 2013.

## Claims

1. A conductive paste for a solar cell, the paste comprising a solids portion dispersed in an organic medium, the solids portion comprising electrically conductive metal, and glass frit, wherein the glass frit consists essentially of:
35 to 65 wt% TeO₂;
20 to 50 wt% Bi₂O₃;
0.1 to 5 wt% Li₂O;
0 to 5 wt% Na₂O;
0.1 to 5 wt% ZnO;
0 to 3 wt% MoO₃;
0.5 to 15 wt% CeO₂;
0 to 3 wt% WO₃;
0 to 5 wt% BaO;
0 to 10 wt% P₂O₅;
0 to 10 wt% of further components selected from the group consisting of GeO₂, CaO, ZrO₂, CuO, AgO and Al₂O₃; and
incidental impurities.

2. A conductive paste according to claim 1 wherein the glass frit comprises 1 to 15 wt% CeO₂.

3. A conductive paste according to claim 1 or 2 wherein any incidental impurity is present at 0.1 wt% or less, 0.05 wt% or less, 0.01 wt% or less, 0.05 wt% or less, 0.001 wt% or less or 0.0001 wt% or less.

4. A conductive paste according to any one of the preceding claims wherein the glass frit comprises 0.5 to 8 wt% in total of one or both of Li₂O and Na₂O.

5. A conductive paste according to any one of the preceding claims wherein the solids portion comprises 85 to 99.9 wt% electrically conductive metal, 0.1 to 15 wt% glass frit and 0 to 10 wt% additive material.

6. A method for the manufacture of a light receiving surface electrode of a solar cell, the method comprising applying a conductive paste as defined in any one of claims 1 to 5 to a semiconductor substrate, and firing the applied conductive paste.

7. A light receiving electrode for a solar cell, the light receiving electrode comprising a conductive track on a semiconductor substrate, wherein the conductive track is obtained or obtainable by firing a paste as defined in any one of claims 1 to 5 on the semiconductor substrate.

8. A solar cell comprising a light receiving electrode as defined in claim 7.

9. Use of a conductive paste as defined in any one of claims 1 to 5 in the manufacture of a light receiving surface electrode of a solar cell.

## Patentansprüche

1. Leitfähige Paste für eine Solarzelle, wobei die Paste einen Feststoffanteil umfasst, der in einem organischen Medium dispergiert ist, wobei der Feststoffanteil elektrisch leitfähiges Metall und Glasfritte umfasst, wobei die Glasfritte im Wesentlichen aus Folgendem besteht:
35 bis 65 Gew.-% TeO₂;
20 bis 50 Gew.-% Bi₂O₃;
0,1 bis 5 Gew.-% Li₂O;
0 bis 5 Gew.-% Na₂O;
0,1 bis 5 Gew.-% ZnO;
0 bis 3 Gew.-% MoO₃;
0,5 bis 15 Gew.-% CeO₂;
0 bis 3 Gew.-% WO₃;
0 bis 5 Gew.-% BaO;
0 bis 10 Gew.-% P₂O₅;
0 bis 10 Gew.-% an weiteren Bestandteilen, die aus der Gruppe ausgewählt sind, welche aus GeO₂, CaO, ZrO₂, CuO, AgO und Al₂O₃ besteht; und
unvermeidbaren Verunreinigungen.

2. Leitfähige Paste gemäß Anspruch 1, wobei die Glasfritte 1 bis 15 Gew.-% CeO₂ umfasst.

3. Leitfähige Paste gemäß Anspruch 1 oder 2, wobei jedwede unvermeidbare Verunreinigung zu höchstens 0,1 Gew.-%, höchstens 0,05 Gew.-%, höchstens 0,01 Gew.-%, höchstens 0,05 Gew.-%, höchstens 0,001 Gew.-% oder höchstens 0,0001 Gew.-% vorliegt.

4. Leitfähige Paste gemäß einem beliebigen der vorhergehenden Ansprüche, wobei die Glasfritte insgesamt 0,5 bis 8 Gew.-% an Li₂O und/oder Na₂O umfasst.

5. Leitfähige Paste gemäß einem beliebigen der vorhergehenden Ansprüche, wobei der Feststoffanteil 85 bis 99,9 Gew.-% an elektrisch leitfähigen Metall, 0,1 bis 15 Gew.-% an Glasfritte und 0 bis 10 Gew.-% an Zusatzstoffen umfasst.

6. Verfahren zur Herstellung einer lichtempfangenden Oberflächenelektrode einer Solarzelle, wobei das Verfahren das Aufbringen einer leitfähigen Paste gemäß den Begriffsbestimmungen in einem beliebigen der Ansprüche 1 bis 5 auf ein Halbleitersubstrat und das Brennen der aufgebrachten leitfähigen Paste umfasst.

7. Lichtempfangende Elektrode für eine Solarzelle, wobei die lichtempfangende Elektrode eine Leiterbahn auf einem Halbleitersubstrat umfasst, wobei die Leiterbahn erhalten wird oder erhalten werden kann, indem eine Paste gemäß den Begriffsbestimmungen in einem beliebigen der Ansprüche 1 bis 5 auf dem Halbleitersubstrat gebrannt wird.

8. Solarzelle, die eine lichtempfangende Elektrode gemäß der Begriffsbestimmung in Anspruch 7 umfasst.

9. Verwendung einer leitfähigen Paste gemäß den Begriffsbestimmungen in einem beliebigen der Ansprüche 1 bis 5 bei der Herstellung einer lichtempfangenden Oberflächenelektrode einer Solarzelle.

## Revendications

1. Pâte conductrice pour cellule solaire, la pâte comprenant une partie matières solides dispersée dans un milieu organique, la partie matières solides comprenant un métal électriquement conducteur, et du verre fritté, le verre fritté consistant essentiellement en :
35 à 65 % en poids de TeO₂ ;
20 à 50 % en poids de Bi₂O₃ ;
0,1 à 5 % en poids de Li₂O ;
0 à 5 % en poids de Na₂O ;
0,1 à 5 % en poids de ZnO ;
0 à 3 % en poids de MoO₃ ;
0,5 à 15 % en poids de CeO₂ ;
0 à 3 % en poids de WO₃ ;
0 à 5 % en poids de BaO ;
0 à 10 % en poids de P₂O₅ ;
0 à 10 % en poids d'autres composants choisis dans le groupe constitué par GeO₂, CaO, ZrO₂, CuO, AgO et Al₂O₃ ; et
des impuretés fortuites.

2. Pâte conductrice selon la revendication 1, dans laquelle le verre fritté comprend de 1 à 15 % en poids de CeO₂.

3. Pâte conductrice selon la revendication 1 ou 2, dans laquelle toute impureté fortuite est présente à raison de 0,1 % en poids ou moins, 0,05 % en poids ou moins, 0,01 % en poids ou moins, 0,05 % en poids ou moins, 0,001 % en poids ou moins ou 0,0001 % en poids ou moins.

4. Pâte conductrice selon l'une quelconque des revendications précédentes, dans laquelle le verre fritté comprend 0,5 à 8 % en poids en tout de l'un de Li₂O et de Na₂O ou des deux.

5. Pâte conductrice selon l'une quelconque des revendications précédentes, dans laquelle la partie matières solides comprend 85 à 99,9 % en poids de métal électriquement conducteur, 0,1 à 15 % en poids de verre fritté et 0 à 10 % en poids de matière additive.

6. Procédé de fabrication d'une électrode de surface réceptrice de lumière d'une cellule solaire, le procédé comprenant l'application d'une pâte conductrice telle que définie dans l'une quelconque des revendications 1 à 5 sur un substrat semi-conducteur, et la cuisson de la pâte conductrice appliquée.

7. Electrode réceptrice de lumière pour cellule solaire, l'électrode réceptrice de lumière comprenant une piste conductrice sur un substrat semi-conducteur, la piste conductrice étant obtenue ou pouvant être obtenue par la cuisson d'une pâte telle que définie dans l'une quelconque des revendications 1 à 5 sur le substrat semi-conducteur.

8. Cellule solaire comprenant une électrode réceptrice de lumière telle que définie dans la revendication 7.

9. Utilisation d'une pâte conductrice telle que définie dans l'une quelconque des revendications 1 à 5 dans la fabrication d'une électrode de surface réceptrice de lumière d'une cellule solaire.
